# EUROPEAN PATENT SPECIFICATION

(11) **EP 4 106 505 B1**
(45) Date of publication and mention of the grant of the patent: **18.03.2026**
(21) Application number: 21179530.7
(22) Date of filing: 15.06.2021
(51) Int. Cl.: H05K 7/20, H05K 7/14

(54) **MODULAR MULTILEVEL CONVERTER**
MODULARER MEHRSTUFIGER WANDLER
CONVERTISSEUR MODULAIRE MULTI-NIVEAUX

(43) Date of publication of application: 21.12.2022
(73) Proprietor: Hitachi Energy Ltd, 8050 Zürich (CH)
(72) Inventor: Gradinger, Thomas Bernhard, 5032 Aarau Rohr (CH); Cottet, Didier, 8050 Zurich (CH); Kapell, Jennie, 771 43 Ludvika (SE); Chen, Nan, 722 10 Västerås (SE); Hillborg, Henrik, 722 10 Västerås (SE); Frank, Andreas, 8046 Zurich (CH); Donzel, Lise, 5430 Wettingen (CH); Beil, Andreas, 8824 Schönenberg ZH (CH)
(74) Representative: AWA Sweden AB

(56) References cited:
- WO-A1-2020/116819
- JP-A- S53 131 436
- US-A1- 2009 126 293
- US-A1- 2013 104 592

## Description

### Technical Field

The present disclosure generally relates to the field of High Voltage Direct Current (HVDC) power converters. More specifically, the present disclosure relates to a modular multilevel converter (MMC) of a HVDC transmission system or a Flexible Alternating Current Transmission System (FACTS).

### Background

MMCs include interconnected converter cell modules, wherein the interconnected converter cell modules form valves of a converter (or converter station). The insulation medium used in such valves is usually air, which may act as the main insulation for an entire valve of the converter.

MMCs are usually arranged indoors, for example inside a large converter hall, wherein the indoor air acts as the main insulation medium for the converter station. The cost of such installations is however quite high, and such installations require also the use of long wall bushing in order to interconnect equipment inside the structure with equipment outside of the structure and require special equipment to control environmental conditions in the hall.

HVDC valves have traditionally been placed outdoors within an air-insulated valve tank, wherein the valve tank comprises a supporting structure covered with steel sheets. One valve tank represents one valve function and each valve tank may be connected to cooling and valve-control equipment located on the ground. Thus, the footprint (i.e. ground area) of a converter comprising such valve tanks is larger than an equivalent indoor converter station. Further, if any component of a valve is in need of repair, replacement, or maintenance, the entire valve has to be turned off, and the valve tank has to be opened up in order to access the component(s).

An example of prior art may be found in WO2020/116819 relating to a submodule cooling system of a power transmission system. This document discloses that a submodule cooling device discharges heat generated by submodules to the outside using air sent in a duct from a cooling air supply source. More specifically, a heat pipe is installed between each of the submodules and the duct to transfer heat generated in a submodule to the air flowing in the duct using the heat pipe.

Another prior art is JP S53 131436 relating to prevention of insulation deterioration in a high voltage thyristor valve.

In light of the above, there is therefore a need for MMCs which are more easily installable, more easily maintainable and/or which provide an increased performance.

### Summary

To at least partially fulfil the above requirements, the present disclosure seeks to provide at least an improved modular multilevel converter as defined in the independent claim. Further embodiments are provided in the dependent claims.

According to a first aspect, a modular multilevel converter is provided. The modular multilevel converter comprises at least one valve comprising a plurality of converter cell modules electrically connected to each other. A converter cell module includes at least one converter cell and an enclosure in which the at least one converter cell is arranged. The modular multilevel converter further comprises a duct system arranged to convey air from an air-conditioning unit into the enclosures of the plurality of converter cell modules. The duct system includes a first manifold and at least one second manifold fluidly connected to the first manifold. The first manifold is connected to the air-conditioning unit. A second manifold is dedicated for connecting the first manifold to at least some of the plurality of converter cell modules. The enclosure of a converter cell module is fluidly and detachably connected to a second manifold via a duct connector attached to the enclosure of the converter cell module.

A converter cell may comprise two or four semiconductor switches, a cell capacitor, electronics for control and communication, and a bypass switch. The cell capacitor may be a DC capacitor. The semiconductor switches and the cell capacitor may be arranged in for example a half-bridge topology or a full-bridge topology.

The air-conditioning unit may be provided to control the air climate (or air conditions) within the duct system. The air-conditioning unit may be provided to control the temperature, the humidity, and/or the cleanliness within the duct system. By the term "control the cleanliness" it is meant, for example, control which particles and/or substances that are allowed into, and/or are removed, from the duct system. The air-conditioning unit may comprise a filter configured to filter any unwanted particles and/or substances.

By the term "duct system" it is further meant, for example, conduit system, passage system or ventilation system. The duct system may be airtight and/or sealed. In other words, the duct system may be configured to prevent fluids, such as air and liquids, from exiting the duct system except through dedicated openings, or outlets, of the duct system. By the term "dedicated openings" it is meant, for example, an opening of a second manifold or an opening of a duct connector.

By the term "manifold" it is further meant, for example, a pipe manifold. The manifold may comprise a main pipe, channel or conduit, branching into several openings to which one or more second manifold may be connected. Alternatively, the manifold may comprise a main pipe, channel or conduit which branches off to secondary pipes, channels, or conduits which may be connected to one or more second manifold. In turn, a second manifold may comprise a main pipe branching into several openings for connection of one or more enclosures of converter cell modules via respective duct connectors. Similarly, a second manifold may comprise a main pipe branching into several secondary pipes, channels or conduits to which converter cell modules may be connected via their respective duct connectors.

The present concept of the modular multilevel converter provides for an outdoor arrangement of the valves, which may reduce the civil engineering work required to construct a converter station hall. The modular multilevel converter is also beneficial for facilitating replacement of an individual converter cell module, for example during service of the outdoor converter valve. Further, although the desired properties of electrical insulation are usually reduced when subjected to outdoor conditions, in comparison to indoor conditions, due to precipitation, high humidity and shifting ambient temperatures, the modular multilevel converter of the present concept provides an improved controlled climate to the components of the converter cells. The controlled climate may be like an indoor climate. Hence, cell components which were originally designed for indoor applications may be used in the modular multilevel converter according to the first aspect, without, or with minimal, requalification.

By providing a duct system arranged to convey air from an air-conditioning unit into the individual enclosures of the plurality of converter cell modules, the temperature and/or the humidity of the converter cell modules can be controlled.

The duct system comprises a first manifold and at least one second manifold, wherein the at least one second manifold is fluidly connected to the first manifold. The duct system may comprise one second manifold, wherein the second manifold is dedicated for connecting the first manifold to all of the plurality of converter cell modules. The duct system may comprise a plurality of second manifolds, wherein a second manifold of the plurality of manifolds is dedicated for connecting the first manifold to at least some of the plurality of converter cells. The plurality of second manifolds may be dedicated for connecting the first manifold to all of the plurality of converter cells.

The first manifold may be configured to allow one or more additional second manifold(s) to be fluidly connected to the first manifold. The first manifold and/or a second manifold of the at least one second manifold may be configured to be extended. For example, a manifold may comprise a first section, wherein the first section comprises a first main pipe branching to secondary pipes or openings (used to connect the second manifolds or duct connectors). A manifold may be extended by connecting the first section of the manifold to a second section comprising a second main pipe branching also to secondary pipes or openings. The first main pipe may be fluidly connected to the second main pipe. Hence, the first manifold may be extended by an addition of a second section. Additional second manifolds may be fluidly connected to secondary pipes or openings of the second section of the first manifold. Correspondingly, a second manifold may be extended by an addition of a second section. Additional converter cell modules may be connected to the secondary pipes or openings of the second section of the second manifold via duct connectors.

The modular multilevel converter may further comprise a fluid conduit system for transporting a cooling fluid between a fluid control unit and the converter cell modules. The fluid conduit system may include a first fluid pipe and a second fluid pipe arranged within the duct system. The at first and second fluid pipe are fluidly and detachably connected to a branch of the fluid conduit system. The branch enters the enclosure of a converter cell module via the duct connector attached to the enclosure of the converter cell module. The first fluid pipe may be configured for transporting cooling fluid from the fluid control unit towards the converter cell modules and the second fluid pipe may be configured for transporting cooling fluid from the converter cell modules towards the fluid control unit.

The cooling fluid may be a cooling liquid or gas, such as for example water. Thus, the fluid conduit system, the fluid pipes and the fluid control unit may be configured as a liquid conduit system, liquid pipes and a liquid control unit, respectively.

A fluid conduit system comprising a first fluid pipe and a second fluid pipe may form a closed loop fluid conduit system. The closed loop fluid conduit system may be configured to collect, via the second fluid pipe, substantially all of the cooling fluid transported towards the converter cell modules via the first fluid pipe. The first fluid pipe and the second fluid pipe may be built up analogously. In other words, the first fluid pipe and the second fluid pipe may be arranged within the duct system alongside each other. A branch of the fluid conduit system that enters the enclosure of a converter cell module may interconnect the first fluid pipe and the second fluid pipe. Such a branch of the fluid conduit system may be configured to receive cooling fluid from the first fluid pipe and to release or eject the received cooling fluid to the second fluid pipe.

In analogy with the duct system, the first and second fluid pipes of the fluid conduit system may be fluid pipe manifolds. The fluid conduit system may be constructed in a similar manner as the duct system, particularly as it is arranged within the duct system. For example, a fluid pipe manifold may comprise a main fluid pipe branching into secondary fluid pipes or including openings to which secondary fluid pipes may be connected. The main fluid pipe may be connected to the fluid control unit. A secondary fluid pipe or an opening of the main fluid pipe may be fluidly and detachably connected to a branch of the fluid conduit system that enters an enclosure of a converter cell module.

The duct system together with the air-conditioning unit may therefore be configured to remove humidity from the enclosures of the converter cell modules, in particular any humidity generated by the fluid conduit system arranged inside the duct system and the enclosures of the converter cell modules for providing heat management (e.g. cooling).

Further, by providing a fluid conduit system for transporting a cooling fluid between a fluid control unit and the converter cell modules, the temperature of the converter cell modules can be controlled.

The first and second fluid pipes of the fluid conduit system being arranged within the duct system may reduce the thermal insulation needed to keep the cooling fluid at a desired temperature. Further, the first and second fluid pipes of the fluid conduit system being arranged within the duct system may reduce the size of the modular multilevel converter in that the fluid conduit system for cooling is integrated in the (air) duct system.

A branch of the fluid conduit system may be configured for transporting fluid within a second manifold of the duct system to the enclosure of a converter cell module which is connected to the second manifold. A branch of the fluid conduit system may be configured to transport fluid to components of the at least one converter cell of the converter cell module. In other words, a branch of the fluid conduit system may be arranged inside an enclosure of a converter cell module such that the cooling fluid is directed towards one or more specific component(s) of a converter cell of the converter cell module. The one or more specific component(s) may be, for example, specific electronic components. The specific electronic components may be components which produce heat, such as semiconductor switches, a capacitor, a resistor, a choke, and/or a snubber circuit. Further, the electronic components subject to heat management may be attached or in thermal connection with a heat sink in which the cooling fluid may circulate.

Due to the enclosure of a converter cell module being fluidly and detachably connected to a second manifold of the duct system via a duct connector, and the first and second fluid pipes being fluidly and detachably connected to a branch of the fluid conduit system, wherein the branch enters the enclosure of a converter cell module via the duct connector, a (e.g. one) converter cell module may be individually disconnected from the duct system and the fluid conduit system. Thus, a (e.g. one) converter cell module may be individually disconnected from the modular multilevel converter, thereby facilitating maintenance of the modular multilevel converter. Further, a converter cell module may be detached, or disconnected, without needing to drain the entire fluid conduit system. In other words, the present fluid conduit system enables dry disconnection of converter cell modules.

The air-conditioning unit may be configured to feed the air to the duct system, and/or the fluid control unit may be configured to feed and to collect the cooling fluid to and from the fluid conduit system.

In other words, the air-conditioning unit may be configured to control the flow rate of the air fed into the duct system. The air-conditioning unit may also be configured to control the conditions of the air fed into the duct system, wherein the conditions may include at least one of temperature, humidity, and air quality. By the term "air quality" it is meant, for example, level of particles and/or contaminants. Hence, a modular multilevel converter with controllable air conditions in the enclosures of the converter cell modules is provided, which may increase the efficiency of the modular multilevel converter.

The fluid control unit may be configured to control the flow rate of the cooling fluid into, and collected from, the fluid conduit system. The fluid control unit may be configured to control the conditions of the cooling fluid fed into the fluid conduit system, wherein the conditions may include at least temperature.

The fluid control unit may be configured to feed cooling fluid into the first fluid pipe of the fluid conduit system and to collect cooling fluid from the second fluid pipe of the fluid conduit system.

The duct system may further comprise an air conduit system configured for transporting air between the air-conditioning unit and the enclosures of the plurality of converter cell modules. The air conduit system may include an air pipe arranged within the duct system. The air pipe may comprise a plurality of air connectors arranged within the at least one second manifold. An air connector may be configured for connecting the air pipe to a branch of the air conduit system. The branch may enter the enclosure of a converter cell module via the duct connector attached to the enclosure.

The air conduit system may be arranged analogously to and/or alongside the fluid conduit system within the duct system. In other words, the air pipe and the first and second fluid pipes may be arranged analogously. By the term "air connector" it is further meant, for example, an air valve, an air connection, or an air coupling. A branch of the air conduit system may be configured to release air into an enclosure of a converter cell module, and/or to collect air from an enclosure of a converter cell module.

The air conduit system may be configured for transporting air from the air-conditioning unit to the enclosures of the plurality of converter cell modules. A converter cell module may be arranged to return air received from the air conduit system to the duct system via the duct connector attached to the converter cell module.

Accordingly, the duct system may be configured as a closed air path, which may be referred to as a first closed air path. In the first closed air path, the air conduit system transports air from the air-conditioning unit to the enclosures of the plurality of converter cells, and the duct system returns the air from the enclosures of the plurality of converter cells to the air-conditioning unit via the duct connectors attached to the enclosures of the plurality of converter cells.

Thus, the air which is transported towards the enclosures of the plurality of converter cells and the air which is collected from the enclosures of the plurality of converter cells are both conveyed inside the duct system. However, the transported air and the collected air (i.e. the two air flows) are separated from each other in that the air transported from the air-conditioning unit to the enclosures of the converter cells is conveyed inside the air conduit system which is arranged inside the duct system.

Alternatively, the air conduit system may be configured for transporting air from the enclosures of the plurality of converter cell modules to the air-conditioning unit. A converter cell module may be arranged to receive air from the duct system via the duct connector attached to the converter cell module. Accordingly, the duct system may be configured as a closed air path, which may be referred to as a second closed air path. In the second closed air path, the duct system transports air from the air-conditioning unit to the enclosures of the plurality of converter cells, and the air conduit system returns the air from the enclosures of the plurality of converter cell modules to the air-conditioning unit.

Thus, for a duct system configured as either of the first closed air path or the second closed air path, the air which is transported towards the enclosures of the plurality of converter cells and the air which is collected from the enclosures of the plurality of converter cells are both conveyed inside the duct system. However, the two air flows are not mixed in that the air transported to the converter cell modules and the air collected from the converter cell modules are separated from each other. In the first closed air path, the transported air and the collected air are separated from each other due to the transported air being conveyed inside the air conduit system which is arranged inside the duct system. In the second closed air path, the transported air and the collected air are separated from each other due to the collected air being conveyed inside the air conduit system which is arranged inside the duct system.

The air-conditioning unit may be further configured to collect the air from the duct system. The air-conditioning unit may thereby be configured to reuse the collected air by feeding it back into the duct system. The air-conditioning unit may be configured to cool or heat, and/or hydrate or dehydrate the collected air before the collected air is fed back into the duct system. The air-conditioning unit may be configured to feed the collected air into an ambient environment. For example, the air-conditioning unit may also be configured to release part of the air returned (back) from the converter cell modules and bring in new air from the surrounding ambient environment.

A converter cell module may be configured to release air received from the duct system through an outlet of the enclosure of the converter cell module. In this configuration, the duct system may therefore provide an open air path in that the air conveyed from the air-conditioning unit to the enclosures of the plurality of converter cell modules via the duct system is released to the ambient environment through outlets of the enclosures of the converter cell modules. In this configuration, the air-conditioning unit may therefore not collect air from the duct system. A duct system providing an open air path may reduce the complexity of the duct system due to a decreased number of components needed. The duct system configured as an open air path may have a smaller size than a duct system configured as a closed air path since the duct system configured as an open air path only needs to be able to convey air towards the enclosures of the converter cell modules, without the need of any separate air conduit system for any one of the air transported to or collected from the converter cell modules.

The modular multilevel converter may further comprise a cable arrangement arranged within the duct system for communication between the plurality of converter cell modules and a control unit of the modular multilevel converter.

The cable arrangement may be connected to electronic components of the converter cell modules for control and communication of the converter cell modules. The cable arrangement may comprise optic fiber cables. A converter cell module of the plurality of converter cell modules may be connected to the cable arrangement via the duct connector attached to the enclosure of the converter cell module. The converter cell modules may be detachably connected to the cable arrangement. The cable arrangement may comprise connection points, wherein a connection point is dedicated for detachably connecting a respective converter cell module to the cable arrangement. A connection point of the connection points may be arranged inside the duct system or within the duct connector. In other words, the connection points may not be arranged inside enclosures of the converter cell modules. Accordingly, a connection point allows for a (i.e. one) converter cell module to be detached from the modular multilevel converter.

In a duct system comprising an air conduit system, the cable arrangement may be located, or arranged, within the duct system, but outside of the air conduit system. The present embodiment is beneficial in that accessibility to the cable arrangement is facilitated.

In a duct system configured as a closed air path, in which return air is conveyed inside the duct system (i.e. not in the air conduit system), the cable arrangement located, or arranged, within the duct system, but outside of the air conduit system, may be exposed to less temperature variation as compared to a cable arrangement which is exposed (directly) to the supply air (i.e. from the air conditioning unit). This is due to the fact that there is less temperature variation in the return air as compared to the supply air, or all of the air. Thus, it is easier to control the relative humidity, i.e. to limit the humidity to a confined range, such as, for example, between 10% and 50%, which may allow for respecting, or adhering to, the specifications of the cable arrangement.

The control unit may be configured to send and receive data, information and/or instructions to and from the converter cell modules via the cable arrangement.

The first fluid pipe and the second fluid pipe may each comprise a plurality of fluid connectors arranged within the at least one second manifold. A fluid connector may be configured for fluidly connecting a respective fluid pipe of the first fluid pipe and the second fluid pipe to the branch of the fluid conduit system.

A fluid connector may include, by way of example, a fluid valve, a fluid connection, or a fluid coupling. A fluid conduit system comprising fluid connectors arranged within the at least one second manifold may allow for detaching, or disconnecting, a (e.g. single) converter cell module. Further, a fluid connector may allow for stopping a flow of cooling fluid into an enclosure of a converter cell module before the converter cell module is detached or disconnected. Hence, the fluid connector allows for an improved modular multilevel converter in terms of maintenance.

The first manifold may comprise at least one electrically insulating section. An electrically insulating section may be arranged between the air-conditioning unit and a second manifold, and/or an electrically insulating section may be provided between two second manifolds. An electrically insulating section may be configured for providing electrical insulation up to a voltage potential difference between the air-conditioning unit and a second manifold, or between two second manifolds.

The at least one electrically insulating section may comprise at least one hollow insulator or at least one hollow-core insulator. The at least one hollow insulator, or hollow-core insulator, may be arranged around a section of the first manifold, in particular between two openings of the first manifold or two secondary pipes of the first manifold connected to second manifolds.

The air-conditioning unit may be fluidly connected to the first manifold via an end of the main pipe of the first manifold or via a secondary pipe of the first manifold. An electrically insulating section of the at least one electrically insulating section may be arranged between an end of the main pipe and an opening or a secondary pipe of the first manifold that is connected to a second manifold.

The at least one second manifold may be electrically conductive or may be on a defined electrical potential. By arranging an electrically insulating section between two second manifolds, one of the two second manifold may be at a first electrical potential and the other second manifold may be at a second electrical potential (different from the first electrical potential).

The air-conditioning unit may for example be at a ground potential. By the term "ground potential" it is further meant, for example, a reference potential, or a potential which is deemed safe for personnel to operate at. With an electrically insulating section arranged between the air-conditioning unit and a second manifold, the manifold may be at an electrical potential which is different from the ground potential.

The at least one electrically insulating section may therefore allow for converter cell modules which are connected to different second manifolds to operate at different electrical potentials.

A duct connector of a converter cell module may comprise an electrical insulator for providing electrical insulation up to a voltage potential difference between the converter cell module and the second manifold connected to the converter cell module.

The electrical insulator of a duct connector may comprise an electrical bushing. The electrical insulator may be arranged around at least a section, or substantially all, of the duct connector. The electrical insulator of a duct connector may allow for a converter cell module to be at an electrical potential which is different from an electrical potential of the second manifold to which the converter cell module is connected to. Further, for a plurality of converter cell modules which are connected to a second manifold, the electrical insulators of the duct connectors of the plurality of converter cell modules allow for the plurality of converter cell modules to operate at different electrical potentials from each other.

The at least one second manifold may comprise a plurality of hatches, wherein each hatch of the plurality of hatches is dedicated for a respective converter cell module. The plurality of hatches may be configured to be opened to allow access to connectors and/or connection points of at least one of the fluid conduit system, the air conduit system and the cable arrangement. The hatches may be configured to be sealed when in a closed state. In other words, the hatches may be configured to prevent fluids from exiting the second manifold when in the closed state.

The air-conditioning unit may be further configured to control air conditions within the duct system depending on a first condition sensed at one or more of the plurality of converter cell modules. Further, the fluid control unit may be configured to cool and/or heat the cooling fluid depending on a second condition sensed at one or more of the plurality of converter cell modules.

The first condition and the second condition may be the same condition. A converter cell module of the plurality of the converter cell modules may comprise at least one sensor. The at least one sensor may be configured to sense at least one of the first condition and the second condition. A first sensor of the at least one sensor may be configured to sense the first condition. A second sensor of the at least one sensor may be configured to sense the second condition. The at least one sensor may be communicatively connected to electronics for control and communication between the converter cell module, the air-conditioning unit and/or the fluid control unit.

The at least one sensor may be configured to sense conditions including at least temperature and humidity.

The plurality of converter cell modules may be grouped as a plurality of layers. The converter cell modules of a layer may be connected to the air-conditioning unit via a dedicated second manifold.

A second manifold dedicated for a layer may be at a different electrical potential from neighboring second manifolds dedicated for other layers. The dedicated second manifolds of the plurality of layers may be at different electrical potentials from each other. At least some of the layers may be in a stacked arrangement. The layers may be arranged at a distance from each other. Air may provide at least part, or substantially all, of the electrical insulation between different layers. The distance between the layers may be configured to provide at least an electrical insulation up to a voltage potential between the layers.

The modular multilevel converter may be a high voltage power converter of a High Voltage Direct Current, HVDC, transmission system or a Flexible Alternating Current Transmission System, FACTS.

### Brief description of the drawings

Exemplifying embodiments will be described below with reference to the accompanying drawings, in which:
Figures 1 - 3 are schematic views of modular multilevel converters including duct systems and converter cell modules.
Figure 4 is a schematic view of a converter cell module which is connected to a duct system.

All the figures are schematic, not necessarily to scale, and generally only show parts which are necessary in order to elucidate embodiments of the present invention, wherein other parts may be omitted or merely suggested. Like reference numerals refer to like elements throughout.

### Detailed description

The present invention will now be described hereinafter with reference to the accompanying drawings, in which exemplifying embodiments are shown.

In the drawings, identical reference numerals denote the same or similar components having a same or similar function, unless specifically stated otherwise.

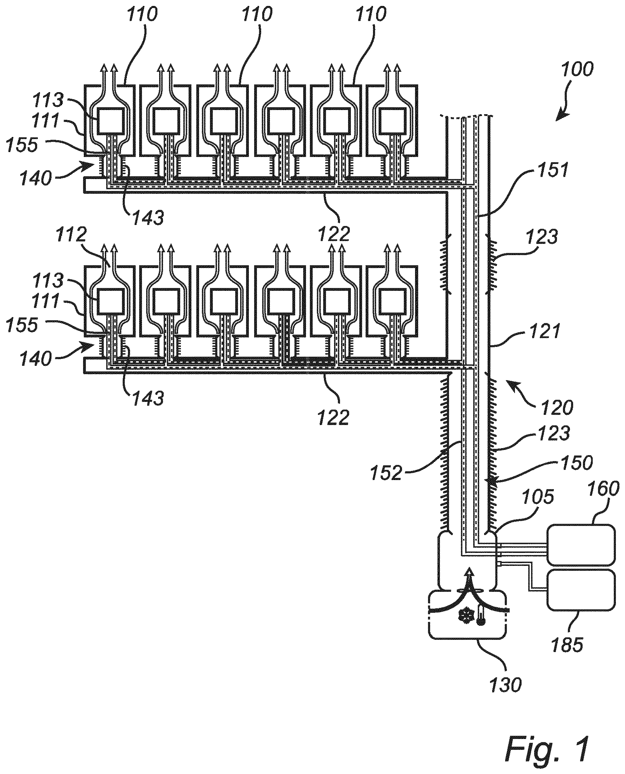

Figure 1 is a schematic view of a modular multilevel converter 100 including a duct system 120 and converter cell modules 110.

The converter cell modules 110 are electrically connected to each other. At least some, or all, of the converter cell modules 110 together form a valve of the modular multilevel converter 100. Each converter cell module 110 includes at least one converter cell 113 and an enclosure 111 in which the at least one converter cell 113 is arranged. In other words, the modular multilevel converter 100 may comprise a plurality of valves, wherein the converter cell modules 110 shown in Figure 1 may be at least some, or all, of the converter cell modules 110 of one or more valves of the modular multilevel converter 100.

The duct system 120 is arranged to convey air from an air-conditioning unit 130 into the enclosures 111 of the converter cell modules 110. The duct system 120 includes a first manifold 121 and two second manifolds 122. The two second manifolds 122 are fluidly connected to the first manifold 121. The connection between the first manifold 121 and a second manifold 122 is arranged at an opening of the first manifold 121. An opening of the first manifold 121 may be understood as a hole through a main pipe of the first manifold 121. Alternatively, the connection may be provided by a secondary pipe which leads into the main pipe of the first manifold 121. The opening(s), or the secondary pipe(s), of the manifold 121 are arranged at the circumference of the main pipe of the first manifold 121. The first manifold 121 is connected to the air-conditioning unit 130. Each of the two second manifolds 122 are dedicated for connecting the first manifold 121 to some of the converter cell modules 110. The enclosures 111 of the converter cell modules 110 are fluidly and detachably connected to the second manifolds 122 via a respective duct connector 140 which is attached to the respective enclosure 111 of the converter cell module 110.

An end of the first manifold 121 is connected to the air-conditioning unit 130 via a connection module 105. The end of the first manifold 121 may be provided as, for example, a bottom, or top, of the main pipe of the first manifold 121.

Optionally, the connection module 105 may also be configured for connecting a fluid conduit system 150 of the modular multilevel converter 100 to a fluid control unit 160.

The optional fluid conduit system 150 may be configured for transporting a cooling fluid between the fluid control unit 160 and the converter cell modules 110. The fluid conduit system 150 includes a first fluid pipe 151 and a second fluid pipe 152 arranged within the duct system 120. Main portions of the first and second fluid pipes 151, 152 are arranged within the first manifold 121 and secondary portions of the first and second fluid pipes 151, 152, which are connected to the respective main portions of the first and second fluid pipes 151, 152, and are arranged in a respective second manifold 122. The secondary portions of the first and second fluid pipes 151, 152 are fluidly and detachably connected to branches 155 of the fluid conduit system 150, wherein a branch 155 enters the enclosure 111 of a respective converter cell module 110 via the duct connector 140 attached to the enclosure 111 of the respective converter cell module 110.

The fluid control unit 160 may be configured to cool and/or heat the cooling fluid depending on a condition sensed at one or more of the converter cell modules 110. The fluid control unit 160 and/or the converter cell modules 110 may comprise sensors configured to sense the condition.

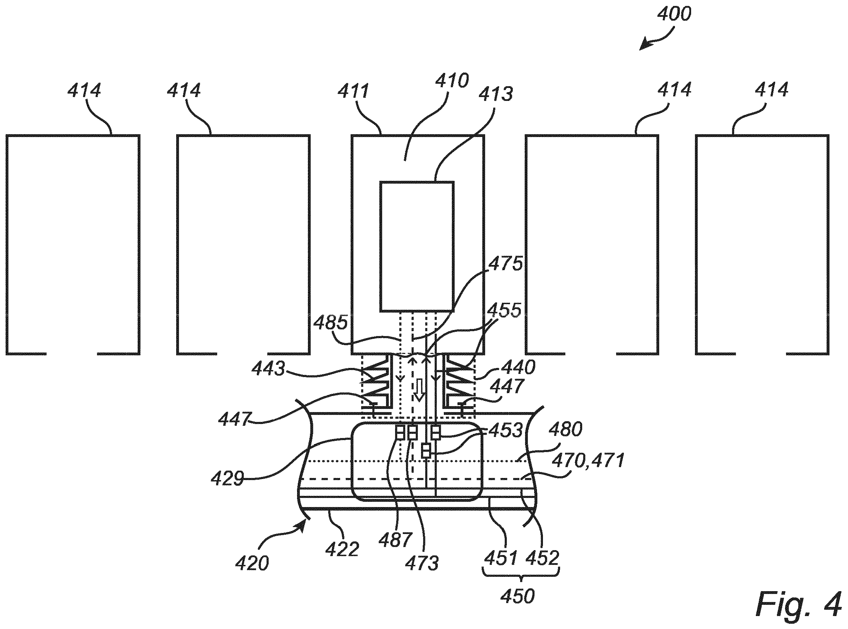

The connection module 105 is configured for connecting a cable arrangement (not shown in Figure 1; see e.g. Figure 4) to a control unit 185 of the modular multilevel converter 100. The cable arrangement is configured for communication between the converter cell modules 110 and the control unit 185.

The air-conditioning unit 130 is configured to feed air to the duct system 120. In the embodiments described with reference to Figure 1, a converter cell module 110 is arranged to release air received from the duct system 120 through an outlet 112 of the enclosure 111 of the converter cell module 110. Figure 1 shows the air-conditioning unit 130 collecting air from an ambient environment and feeding the air into the first manifold 121. The air is conveyed to the second manifolds 122 via the first manifold 121 and then conveyed from the second manifolds 122 into the enclosures 111 of the converter cell modules 110 via the duct connectors 140.

The air-conditioning 130 unit may be configured to control air conditions within the duct system 120 depending on a condition sensed at one or more of the converter cell modules 110. The air-conditioning unit 130 and/or the converter cell modules 110 may comprise sensors configured to sense the condition.

In the example shown in Figure 1, the plurality of converter cell modules are arranged as a stack of two layers, wherein one second manifold is connected to a first group or set of converter cell modules and another second manifold is connected to a second group or set of converter cell modules of the plurality of converter cell modules. In this configuration, the first manifold extends vertically from the ground and the two second manifolds, and thereby the two associated layers of converter cell modules, are arranged at two different levels along the first manifold (or the direction of extension of the first manifold). It will be appreciated that this is just an example and the plurality of converter cell modules may be arranged at more than two levels and thus be distributed among more than two second manifolds.

Further, the first manifold 121 may extends past the two second manifolds 122, which is indicated by a curved and dashed line across an end of the first manifold 121. It is to be understood that this indicates that the modular multilevel converter 100 may comprise additional second manifolds fluidly connected to the first manifold 121 for connection of additional converter modules.

Further, the first manifold 121 may comprise two electrically insulating sections 123. A first electrically insulating section 123 of the two electrically insulating sections 123 shown in Figure 1 may be configured as a hollow core insulator which is arranged (circumferentially) around a first section of the first manifold 121, wherein the first section is located between the air-conditioning unit 130 and the second manifold 122 closest to the air-conditioning unit 130. The first electrically insulating section 123 is configured to provide electrical insulation up to a voltage potential difference between the air-conditioning unit 130 and the second manifold 122 closest to the air-conditioning unit 130. The potential at the air-conditioning unit 130 may be the same potential as that of the connection module 105, the fluid control unit 160, and/or the control unit 185. A second electrically insulating section 123 of the two electrically insulating sections 123 may be configured as a hollow core insulator which is arranged (circumferentially) around a second section of the first manifold 121, wherein the second section is located between the two second manifolds 122. The second electrically insulating section 123 is configured to provide electrical insulation up to a voltage potential difference between the two second manifolds 122.

The duct connectors 140 of the converter cell modules 100 may also comprise electrical insulators 143. The electrical insulators 143 are configured as hollow core insulators which are circumferentially arranged around the respective duct connectors 140. An electrical insulator 143 is configured for providing electrical insulation up to a voltage potential difference between the converter cell module 110 and the second manifold 122 connected to the converter cell module 110.

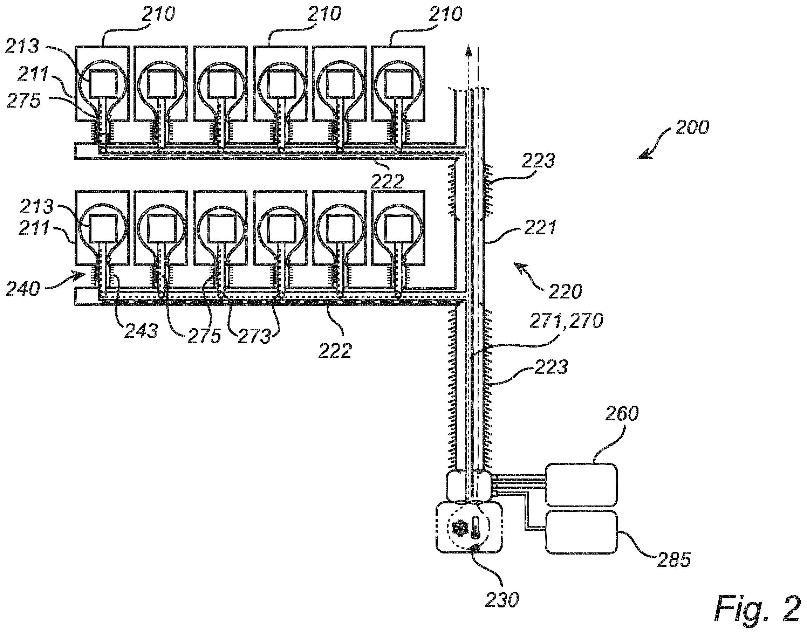

Figure 2 is a schematic view of a modular multilevel converter 200 including a duct system 220 and converter cell modules 210.

The modular multilevel converter 200 shown in Figure 2 is equivalent to the modular multilevel converter 100 shown in Figure 1 except that a difference between the duct system 220 and the duct system 110 described with reference to Figure 1 is that the duct system 220 comprises a (separate) conduit system 270. Thus, the enclosures 213 of the converter cell modules 210 of the modular multilevel converter 200, the first manifold 221of the duct system 220, the electrically insulating section 223 of the first manifold 221, the fluid control unit 260 and the control unit 285 are equivalent to the respective components of the modular multilevel converter 100 shown in Figure 1.

The conduit system 270 is configured for transporting air between the air-conditioning unit 230 and enclosures 211 of the converter cell modules 210. The air conduit system 270 includes an air pipe 271 arranged within the duct system 200. The air pipe 271 comprises a plurality of air connectors 273. The air connectors 273 are arranged within the two second manifolds 222 of the duct system 220. The air connectors 273 are configured for connecting the air pipe 271 to a branch 275 of the air conduit system 270. The branch 275 enters the enclosure 211 of a respective converter cell module 210 via a duct connector 240 attached to the enclosure 211. In other words, each air connector 273 is configured for connecting a respective branch 275 of the air conduit system 270.

A difference between the air-conditioning unit 230 shown in Figure 2 and the air-conditioning unit 130 described with reference to for example Figure 1 is that the air-conditioning unit 230 is further configured to collect air from the duct system 220.

The air conduit system 270 is configured for transporting air from the air-conditioning unit 270 to the enclosures 211 of the converter cell modules 210. The converter cell modules 210 are arranged to return air received from the air conduit system 270 to the duct system 220 via the duct connectors 240 attached thereto (i.e. via the duct connectors attached to the converter cell modules 210). A converter cell module 210 may therefore be assembled to form a sealed container comprising an opening, wherein the opening of the sealed container is attached to the duct connector 240. The duct connector 240 comprises an electrical insulator 243. By transporting air into the enclosure 211 via the air conduit system 270, at least some air is pushed out back to the duct system 220 through the duct connector 240. Thus, a closed air path is obtained within the duct system 220. In other words, the air is fed by the air-conditioning unit 230 into the air conduit system 270 arranged within the duct system 220 and is collected by the air-conditioning unit 230 from the duct system 220.

In another embodiment, the air-conditioning system 270 and the duct system 220 may be operated in a different manner. For example, the air conduit system 270 may be configured for transporting air from the enclosures 211 of the converter cell modules 210 to the air-conditioning unit 230, and the converter cell modules 210 may be arranged to receiver air from the duct system 210 via the duct connector 240 attached to the converter cell module 210. Thus, an alternative closed air path is obtained within the duct system 220.

It is to be understood that the modular multilevel converter 200 may optionally comprise a fluid conduit system as described with reference to for example Figure 1. However, for the sake of clarity, the fluid pipes of the fluid conduit system are not shown in Figure 2. The fluid pipes may be arranged analogously to the air pipe 271 of the air conduit system 270.

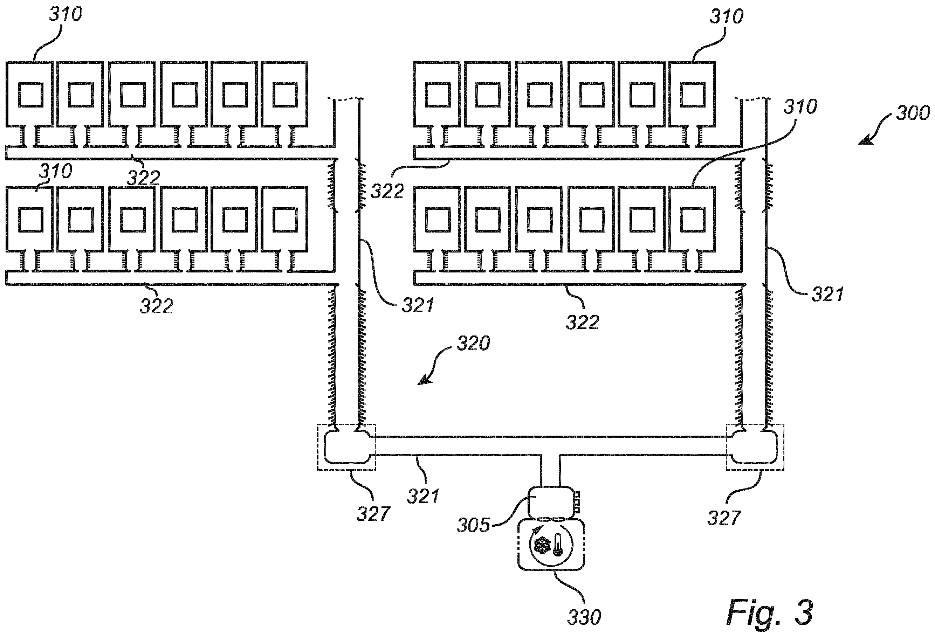

Figure 3 is a schematic view of a modular multilevel converter 300 including a duct system 320 and converter cell modules 310.

A difference between the duct system 320 and the duct systems 120 and 220 described with reference to for example Figures 1 and 2 is that the first manifold 321 of the duct system 320 is arranged or designed differently. The first manifold 321 is fluidly connected to an air-conditioning unit 330 via a connection module 305. The first manifold 321 comprises three main pipes, wherein a first main pipe of the three main pipes is connected to the air-conditioning unit 330. Two second main pipes of the three main pipes are connected to the air-conditioning unit 330 via the first main pipe. Ends of the second main pipes are connected to a respective end of the first main pipe, at a respective connection point 327. **It** will be appreciated that the first manifold 321 may be extended by connecting one or more additional main pipe(s) to one or more connection point(s) 327 of the first manifold 321. Accordingly, the duct system 320 can be extended.

In the present example, the duct system 320 comprises four second manifolds 322. Two second manifolds 322 are connected to a respective second main pipe of the first manifold 321. The second manifolds 322 may be extended to allow for connection of additional converter cell modules. The converter cell modules 310 connected to a (i.e. single) dedicated second manifold 322 may form a layer of converter cell modules 310. Thus, the duct system 320 can be extended by extending a second manifold 322, connecting an additional second manifold to the first manifold 321, and/or extending the first manifold 321.

It is to be understood that the modular multilevel converter 300 may also optionally comprise a fluid conduit system and/or an air conduit system as described with reference to for example Figures 1 and 2 arranged within the duct system 320.

Figure 4 is a schematic view of a portion of a modular multilevel converter 400 illustrating the connection of a converter cell module 410 to a duct system 420.

In the present example, the converter cell module 410 is arranged between four neighboring converter cell modules 414. The neighboring converter cell modules 414 may be equivalent to the converter cell module 410 placed in the middle of this arrangement of five converter cell modules. The converter cell module 410 comprises one or more converter cell(s) 413 arranged inside an enclosure 411 of the converter cell module 410. The enclosure 411 is fluidly and detachably connected to a second manifold 422 of the duct system 420 via a duct connector 440.

The duct connector 440 is attached to the enclosure 411 of the converter cell module 410. The duct connector 440 is fluidly and detachably connected to the second manifold by fastening means 447. The fastening means 447 are arranged through flanges of the duct connector 440 and the second manifold 422. The fastening means 447 may be configured as, for example, bolts, nuts, screws and/or clips. The duct connector 440 comprises an electrical insulator 443. The electrical insulator 443 is configured for providing electrical insulation up to a voltage potential difference between the converter cell module 410 and the second manifold 422.

In the embodiment depicted in Figure 4, the modular multilevel converter 400 comprises also a fluid conduit system 450 arranged at least in part within the second manifold 422. The fluid conduit system 450 comprises a first fluid pipe 451 and a second fluid pipe 452. The first fluid pipe 451 is configured for transporting cooling fluid from a fluid control unit (not shown in Figure 4; see e.g. Figures 1 or 2) towards the converter cell modules 410, 414. The second fluid pipe 452 is configured for transporting cooling fluid from the converter cell modules 410, 414 towards the fluid control unit. The fluid pipes 451, 452 comprise a plurality of fluid connectors 453 arranged within the second manifold 422. A (i.e. one) fluid connector 453 is configured for fluidly connecting a respective fluid pipe 451, 452 to a branch 455 of the fluid conduit system 450. The branch 455 enters the enclosure 411 of the converter cell module 410 via the duct connector 440 attached to the enclosure 411 of the converter cell module 410. The fluid pipes 451, 452 may be connected to two ends of the same branch 455.

The duct system 420 comprises an air conduit system 470 configured for transporting air between an air-conditioning unit (not shown in Figure 4; see e.g. Figures 1 or 2) and the enclosures 411 of the converter cell modules 410, 414. The air conduit system 470 includes an air pipe 471 arranged within the duct system 420. The air pipe 471 comprises a plurality of air connectors 473 arranged within the second manifold 422, wherein one air connector 473 is shown in Figure 4. The air connector 473 is configured for connecting the air pipe 471 to a branch 475 of the air conduit system 470. The branch 475 enters the enclosure 411 of the converter cell module 410 via the duct connector 440 attached to the enclosure 411.

The modular multilevel converter 400 further comprises a cable arrangement 480. The cable arrangement 480 is located within the duct system 420. The cable arrangement 480 is configured for communication between the converter cell modules 410, 414 and a control unit (not shown in Figure 4; see e.g. Figures 1 or 2) of the modular multilevel converter 400. The cable arrangement comprises connection points 487, wherein Figure 4 shows one connection point 487. The connection point 487 is dedicated for detachably connecting the converter cell module 410 to the cable arrangement 480. The connection point 487 is arranged inside the second manifold 422. The converter cell module 410 is connected to the cable arrangement 480 via a branch 485 of the cable arrangement 480, wherein the branch 485 is connected to the cable arrangement 480 via the connection point 487.

The duct system 420 comprises a hatch 429. The hatch 429 is arranged at an opening of the second manifold 422. The hatch 429 is configured for providing access into the second manifold 422. The hatch 429 is configured to be (manually) switched between a closed state and an opened state. In the closed state, the hatch 429 is configured to seal the opening of the second manifold 422. In the opened state, the hatch 429 is configured to allow access into the second manifold 429 via the opening of the second manifold 422. When the hatch 429 is in the opened state, an operator, or a service technician, is able to access the fluid connectors 453 of the fluid conduit system 450, the air connector 473 of the air conduit system 470, and/or the connection point 487 of the cable arrangement 485 for the converter cell module 410. In other words, the hatch 429 is configured to allow access to connectors and/or connection points dedicated for the (i.e. one) converter cell module 410. Hence, an operator can easily disconnect one converter cell module 410 from the modular multilevel converter 400 in order to replace or repair the converter cell module 410.

Only a portion of the duct system 420 is shown, wherein the portion shows how the converter cell module 410 is connected to the duct system 420, the air pipe 471, the fluid conduit system 450 and the cable arrangement 480. However, it is to be understood that the neighboring converter cell modules 414, as well as additional converter cell modules of the modular multilevel converter 400 which are not shown in Figure 4, may be connected to the duct system 420, the air pipe 471, the fluid conduit system 450 and the cable arrangement 480 in a similar, or substantially identical, manner. Further, it is to be understood that the second manifold 422 may comprise additional hatches which are dedicated for the other converter cell modules 414. The second manifold 422 may be connected to the air-conditioning unit, the fluid control unit, and the control unit in a manner similar to what was described in the text referencing, for example, Figures 1 to 3.

While the present invention has been illustrated in the appended drawings and the foregoing description, such illustration is to be considered illustrative or exemplifying and not restrictive; the present invention is set out as defined in the appended set of claims.

In the appended claims, the word "comprising" does not exclude other elements or steps, and the indefinite article "a" or "an" does not exclude a plurality. Any reference signs in the claims should not be construed as limiting the scope.

## Claims

1. A modular multilevel converter (100-400) including:
at least one valve comprising a plurality of converter cell modules (110, 210, 310, 410) electrically connected to each other, wherein a converter cell module includes at least one converter cell and an enclosure (111, 211, 411) in which said at least one converter cell is arranged;
a duct system (120, 220, 420) arranged to convey air from an air-conditioning unit (130, 230, 330) into the enclosures of the plurality of converter cell modules, said duct system including a first manifold (121, 221, 321) and at least one second manifold (122, 222, 322, 422) fluidly connected to said first manifold, wherein the first manifold is connected to the air-conditioning unit and wherein a second manifold is dedicated for connecting the first manifold to at least some of the plurality of converter cell modules, and wherein the enclosure of a converter cell module is fluidly and detachably connected to a second manifold via a duct connector (140, 240, 440) attached to the enclosure of the converter cell module.

2. A modular multilevel converter according to claim 1, wherein the air-conditioning unit is configured to feed said air to the duct system.

3. A modular multilevel converter according to claim 1 or 2, wherein the duct system further comprises an air conduit system (270, 470) configured for transporting air between the air-conditioning unit and the enclosures of the plurality of converter cell modules, wherein the air conduit system includes an air pipe (271, 471) arranged within the duct system, the air pipe comprising a plurality of air connectors (273, 473) arranged within the at least one second manifold, wherein an air connector is configured for connecting the air pipe to a branch (275, 475) of the air conduit system, wherein the branch enters the enclosure of a converter cell module via the duct connector attached to the enclosure.

4. A modular multilevel converter according to claim 3, wherein the air conduit system is configured for transporting air from the air-conditioning unit to the enclosures of the plurality of converter cell modules, and wherein a converter cell module is arranged to return air received from the air conduit system to the duct system via the duct connector attached to the converter cell module.

5. A modular multilevel converter according to claim 3, wherein the air conduit system is configured for transporting air from the enclosures of the plurality of converter cell modules to the air-conditioning unit, and wherein a converter cell module is arranged to receive air from the duct system via the duct connector attached to the converter cell module.

6. A modular multilevel converter according to any one of the preceding claims, wherein the air-conditioning unit is further configured to collect said air from the duct system.

7. A modular multilevel converter according to any one of claims 1 to 3, wherein a converter cell module is configured to release air received from the duct system through an outlet of the enclosure of the converter cell module.

8. A modular multilevel converter according to any one of the preceding claims, further comprising a cable arrangement (480) arranged within the duct system for communication between the plurality of converter cell modules and a control unit (185, 285) of the modular multilevel converter.

9. A modular multilevel converter according to any one of the preceding claims, wherein the air-conditioning unit is further configured to control air conditions within the duct system depending on a condition sensed at one or more of the plurality of converter cell modules.

10. A modular multilevel converter according to any one of the preceding claims, further comprising a fluid conduit system (150, 450) including a first fluid pipe (151, 451) and a second fluid pipe (152, 452) arranged within the duct system, wherein the first and second fluid pipes are fluidly and detachably connected to a branch (155, 455) of the fluid conduit system, wherein the branch enters the enclosure of a converter cell module via the duct connector attached to the enclosure of the converter cell module, wherein the first fluid pipe is configured for transporting cooling fluid from a fluid control unit towards the converter cell modules and the second fluid pipe is configured for transporting cooling fluid from the converter cell modules towards the fluid control unit.

11. A modular multilevel converter according to claim 10, wherein the first fluid pipe and the second fluid pipe comprise a plurality of fluid connectors (453) arranged within the at least one second manifold, wherein a fluid connector is configured for fluidly connecting a respective fluid pipe of the first fluid pipe and the second fluid pipe to the branch of the fluid conduit system.

12. A modular multilevel converter according to any one of claims 10-11, wherein the fluid control unit is further configured to cool and/or heat said cooling fluid depending on a condition sensed at one or more of the plurality of converter cell modules.

13. A modular multilevel converter according to any one of the preceding claims, wherein the first manifold comprises at least one electrically insulating section (123, 223), wherein an electrically insulating section is arranged between the air-conditioning unit and a second manifold, and/or wherein an electrically insulating section is provided between two second manifolds, wherein an electrically insulating section is configured for providing electrical insulation up to a voltage potential difference between the air-conditioning unit and a second manifold, or between two second manifolds.

14. A modular multilevel converter according to any one of the preceding claims, wherein a duct connector of a converter cell module comprises an electrical insulator (143, 243, 443) for providing electrical insulation up to a voltage potential difference between the converter cell module and the second manifold connected to the converter cell module.

15. A modular multilevel converter according to any one of the preceding claims, wherein the plurality of converter cell modules is grouped as a plurality of layers, and wherein the converter cell modules of a layer are connected to the air-conditioning unit via a dedicated second manifold.

16. A modular multilevel converter according to any one of the preceding claims, wherein the converter is a high voltage power converter of a High Voltage Direct Current, HVDC, transmission system or a Flexible Alternating Current Transmission System, FACTS.

## Patentansprüche

1. Modularer mehrstufiger Umrichter (100-400), der Folgendes umfasst:
mindestens ein Ventil, das eine Mehrzahl von Umrichterzellenmodulen (110, 210, 310, 410) umfasst, die elektrisch miteinander verbunden sind, wobei ein Umrichterzellenmodul mindestens eine Umrichterzelle und ein Gehäuse (111, 211, 411) umfasst, in dem die mindestens eine Umrichterzelle angeordnet ist;
ein Kanalsystem (120, 220, 420), das so angeordnet ist, dass es Luft von einer Klimatisierungseinheit (130, 230, 330) in die Gehäuse der Mehrzahl von Umrichterzellenmodulen befördert, wobei das Kanalsystem einen ersten Verteiler (121, 221, 321) und mindestens einen strömungstechnisch mit dem ersten Verteiler verbundenen zweiten Verteiler (122, 222, 322, 422) umfasst, wobei der erste Verteiler mit der Klimatisierungseinheit verbunden ist und wobei ein zweiter Verteiler zum Verbinden des ersten Verteilers mit zumindest einigen der Mehrzahl von Umrichterzellenmodulen dediziert ist, und wobei das Gehäuse eines Umrichterzellenmoduls über einen an dem Gehäuse des Umrichterzellenmoduls angebrachten Kanalverbinder (140, 240, 440) strömungstechnisch und abnehmbar mit einem zweiten Verteiler verbunden ist.

2. Modularer mehrstufiger Umrichter nach Anspruch 1, wobei die Klimatisierungseinheit dazu ausgelegt ist, die Luft zu dem Kanalsystem zu speisen.

3. Modularer mehrstufiger Umrichter nach Anspruch 1 oder 2, wobei das Kanalsystem ferner ein Luftleitungssystem (270, 470) umfasst, das zum Transportieren von Luft zwischen der Klimatisierungseinheit und den Gehäusen der Mehrzahl von Umrichterzellenmodulen ausgelegt ist, wobei das Luftleitungssystem ein Luftrohr (271, 471) umfasst, das innerhalb des Kanalsystems angeordnet ist, wobei das Luftrohr eine Mehrzahl von Luftverbindern (273, 473) umfasst, die innerhalb des mindestens einen zweiten Verteilers angeordnet sind, wobei ein Luftverbinder zum Verbinden des Luftrohrs mit einem Zweig (275, 475) des Luftleitungssystems ausgelegt ist, wobei der Zweig über den an dem Gehäuse angebrachten Kanalverbinder in das Gehäuse eines Umrichterzellenmoduls eintritt.

4. Modularer mehrstufiger Umrichter nach Anspruch 3, wobei das Luftleitungssystem zum Transportieren von Luft von der Klimatisierungseinheit zu den Gehäusen der Mehrzahl von Umrichterzellenmodulen ausgelegt ist, und wobei ein Umrichterzellenmodul so angeordnet ist, dass es von dem Luftleitungssystem aufgenommene Luft über den an dem Umrichterzellenmodul angebrachten Kanalverbinder zu dem Kanalsystem zurückführt.

5. Modularer mehrstufiger Umrichter nach Anspruch 3, wobei das Luftleitungssystem zum Transportieren von Luft von den Gehäusen der Mehrzahl von Umrichterzellenmodulen zu der Klimatisierungseinheit ausgelegt ist, und wobei ein Umrichterzellenmodul so angeordnet ist, dass es Luft aus dem Kanalsystem über den an dem Umrichterzellenmodul angebrachten Kanalverbinder aufnimmt.

6. Modularer mehrstufiger Umrichter nach einem der vorhergehenden Ansprüche, wobei die Klimatisierungseinheit ferner dazu ausgelegt ist, die Luft aus dem Kanalsystem aufzufangen.

7. Modularer mehrstufiger Umrichter nach einem der Ansprüche 1 bis 3, wobei ein Umrichterzellenmodul dazu ausgelegt ist, von dem Kanalsystem aufgenommene Luft durch einen Auslass des Gehäuses des Umrichterzellenmoduls abzugeben.

8. Modularer mehrstufiger Umrichter nach einem der vorhergehenden Ansprüche, der ferner eine Kabelanordnung (480) umfasst, die innerhalb des Kanalsystems zur Kommunikation zwischen der Mehrzahl von Umrichterzellenmodulen und einer Steuereinheit (185, 285) des modularen mehrstufigen Umrichters angeordnet ist.

9. Modularer mehrstufiger Umrichter nach einem der vorhergehenden Ansprüche, wobei die Klimatisierungseinheit ferner dazu ausgelegt ist, Luftbedingungen innerhalb des Kanalsystems in Abhängigkeit von einem Zustand zu steuern, der an einem oder mehreren der Mehrzahl von Umrichterzellenmodulen erfasst wird.

10. Modularer mehrstufiger Umrichter nach einem der vorhergehenden Ansprüche, der ferner ein Fluidleitungssystem (150, 450) umfasst, das ein erstes Fluidrohr (151, 451) und ein zweites Fluidrohr (152, 452) umfasst, die innerhalb des Kanalsystems angeordnet sind, wobei das erste und das zweite Fluidrohr strömungstechnisch und abnehmbar mit einem Zweig (155, 455) des Fluidleitungssystems verbunden sind, wobei der Zweig über den an dem Gehäuse des Umrichterzellenmoduls angebrachten Kanalverbinder in das Gehäuse eines Umrichterzellenmoduls eintritt, wobei das erste Fluidrohr zum Transportieren von Kühlfluid von einer Fluidsteuereinheit in Richtung der Umrichterzellenmodule ausgelegt ist und das zweite Fluidrohr zum Transportieren von Kühlfluid von den Umrichterzellenmodulen in Richtung der Fluidsteuereinheit ausgelegt ist.

11. Modularer mehrstufiger Umrichter nach Anspruch 10, wobei das erste Fluidrohr und das zweite Fluidrohr ein Mehrzahl von Fluidverbindern (453) umfassen, die innerhalb des mindestens einen zweiten Verteilers angeordnet sind, wobei ein Fluidverbinder zum strömungstechnischen Verbinden eines jeweiligen Fluidrohrs des ersten Fluidrohrs und des zweiten Fluidrohrs mit dem Zweig des Fluidleitungssystems ausgelegt ist.

12. Modularer mehrstufiger Umrichter nach einem der Ansprüche 10-11, wobei die Fluidsteuereinheit ferner dazu ausgelegt ist, das Kühlfluid in Abhängigkeit von einer an einem oder mehreren der Mehrzahl von Umrichterzellenmodulen erfassten Bedingung zu kühlen und/oder zu erwärmen.

13. Modularer mehrstufiger Umrichter nach einem der vorhergehenden Ansprüche, wobei der erste Verteiler mindestens einen elektrisch isolierenden Abschnitt (123, 223) umfasst, wobei ein elektrisch isolierender Abschnitt zwischen der Klimatisierungseinheit und einem zweiten Verteiler angeordnet ist, und/oder wobei ein elektrisch isolierender Abschnitt zwischen zwei zweiten Verteilern bereitgestellt ist, wobei ein elektrisch isolierender Abschnitt zum Bereitstellen einer elektrischen Isolation bis zu einer Spannungspotentialdifferenz zwischen der Klimatisierungseinheit und einem zweiten Verteiler oder zwischen zwei zweiten Verteilern ausgelegt ist.

14. Modularer mehrstufiger Umrichter nach einem der vorhergehenden Ansprüche, wobei ein Kanalverbinder eines Umrichterzellenmoduls einen elektrischen Isolator (143, 243, 443) zum Bereitstellen einer elektrischen Isolation bis zu einer Spannungspotentialdifferenz zwischen dem Umrichterzellenmodul und dem mit dem Umrichterzellenmodul verbundenen zweiten Verteiler umfasst.

15. Modularer mehrstufiger Umrichter nach einem der vorhergehenden Ansprüche, wobei die Mehrzahl von Umrichterzellenmodulen als eine Mehrzahl von Schichten gruppiert ist, und wobei die Umrichterzellenmodule einer Schicht über einen dedizierten zweiten Verteiler mit der Klimatisierungseinheit verbunden sind.

16. Modularer mehrstufiger Umrichter nach einem der vorhergehenden Ansprüche, wobei der Umrichter ein Hochspannungsleistungsumrichter eines Hochspannungsgleichstrom-, HVDC-, Übertragungssystems oder eines flexiblen Drehstromübertragungssystems, FACTS, ist.

## Revendications

1. Convertisseur modulaire multiniveau (100-400) comportant :
au moins une valve comprenant une pluralité de modules de cellules de convertisseur (110, 210, 310, 410) connectés électriquement entre eux, un module de cellules de convertisseur comprenant au moins une cellule de convertisseur et une enceinte (111, 211, 411) dans laquelle est agencée ladite au moins une cellule de convertisseur ;
un système de gaine (120, 220, 420) agencé pour acheminer de l'air depuis une unité de conditionnement d'air (130, 230, 330) jusque dans les enceintes de la pluralité de modules de cellules de convertisseur, ledit système de gaine comportant un premier collecteur (121, 221, 321) et au moins un deuxième collecteur (122, 222, 322, 422) connecté fluidiquement audit premier collecteur, le premier collecteur étant connecté à l'unité de conditionnement d'air et un deuxième collecteur étant dédié pour connecter le premier collecteur à au moins certains de la pluralité de modules de cellules de convertisseur, et l'enceinte d'un module de cellules de convertisseur étant connectée fluidiquement et de manière détachable à un deuxième collecteur par l'intermédiaire d'un connecteur de gaine (140, 240, 440) fixé à l'enceinte du module de cellules de convertisseur.

2. Convertisseur modulaire multiniveau selon la revendication 1, dans lequel l'unité de conditionnement d'air est configurée pour introduire ledit air dans le système de gaine.

3. Convertisseur modulaire multiniveau selon la revendication 1 ou 2, dans lequel le système de gaine comprend en outre un système de conduite d'air (270, 470) configuré pour transporter de l'air entre l'unité de conditionnement d'air et les enceintes de la pluralité de modules de cellules de convertisseur, le système de conduite d'air comportant un tuyau d'air (271, 471) agencé à l'intérieur du système de gaine, le tuyau d'air comprenant une pluralité de connecteurs d'air (273, 473) agencés à l'intérieur de l'au moins un deuxième collecteur, un connecteur d'air étant configuré pour connecter le tuyau d'air à un embranchement (275, 475) du système de conduite d'air, l'embranchement pénétrant dans l'enceinte d'un module de cellules de convertisseur par l'intermédiaire du connecteur de gaine fixé à l'enceinte.

4. Convertisseur modulaire multiniveau selon la revendication 3, dans lequel le système de conduite d'air est configuré pour transporter de l'air depuis l'unité de conditionnement d'air vers les enceintes de la pluralité de modules de cellules de convertisseur, et dans lequel un module de cellules de convertisseur est agencé pour renvoyer l'air reçu du système de conduite d'air vers le système de gaine par l'intermédiaire du connecteur de gaine fixé au module de cellules de convertisseur.

5. Convertisseur modulaire multiniveau selon la revendication 3, dans lequel le système de conduite d'air est configuré pour transporter de l'air depuis les enceintes de la pluralité de modules de cellules de convertisseur vers l'unité de conditionnement d'air, et dans lequel un module de cellules de convertisseur est agencé pour recevoir l'air du système de gaine par l'intermédiaire du connecteur de gaine fixé au module de cellules de convertisseur.

6. Convertisseur modulaire multiniveau selon l'une quelconque des revendications précédentes, dans lequel l'unité de conditionnement d'air est configurée en outre pour collecter ledit air depuis le système de gaine.

7. Convertisseur modulaire multiniveau selon l'une quelconque des revendications 1 à 3, dans lequel un module de cellules de convertisseur est configuré pour libérer l'air reçu du système de gaine par une sortie de l'enceinte du module de cellules de convertisseur.

8. Convertisseur modulaire multiniveau selon l'une quelconque des revendications précédentes, comprenant en outre un agencement de câbles (480) agencé à l'intérieur du système de gaine pour assurer la communication entre la pluralité de modules de cellules de convertisseur et une unité de commande (185, 285) du convertisseur modulaire multiniveau.

9. Convertisseur modulaire multiniveau selon l'une quelconque des revendications précédentes, dans lequel l'unité de conditionnement d'air est configurée en outre pour réguler des conditions de l'air à l'intérieur du système de gaine en fonction d'une condition détectée au niveau d'un ou de plusieurs modules de la pluralité de modules de cellules de convertisseur.

10. Convertisseur modulaire multiniveau selon l'une quelconque des revendications précédentes, comprenant en outre un système de conduite de fluide (150, 450) comportant un premier tuyau de fluide (151, 451) et un deuxième tuyau de fluide (152, 452) agencés à l'intérieur du système de gaine, les premier et deuxième tuyaux de fluide étant connectés fluidiquement et de manière détachable à un embranchement (155, 455) du système de conduite de fluide, l'embranchement pénétrant dans l'enceinte d'un module de cellules de convertisseur par l'intermédiaire du connecteur de gaine fixé à l'enceinte du module de cellules de convertisseur, le premier tuyau de fluide étant configuré pour transporter du fluide de refroidissement depuis une unité de régulation de fluide vers les modules de cellules de convertisseur et le deuxième tuyau de fluide étant configuré pour transporter du fluide de refroidissement depuis les modules de cellules de convertisseur vers l'unité de régulation de fluide.

11. Convertisseur modulaire multiniveau selon la revendication 10, dans lequel le premier tuyau de fluide et le deuxième tuyau de fluide comprennent une pluralité de connecteurs de fluide (453) agencés à l'intérieur de l'au moins un deuxième collecteur, un connecteur de fluide étant configuré pour connecter fluidiquement un tuyau de fluide respectif du premier tuyau de fluide et du deuxième tuyau de fluide à l'embranchement du système de conduite de fluide.

12. Convertisseur modulaire multiniveau selon l'une quelconque des revendications 10 à 11, dans lequel l'unité de régulation de fluide est configurée en outre pour refroidir et/ou chauffer ledit fluide de refroidissement en fonction d'une condition détectée au niveau d'un ou de plusieurs modules de la pluralité de modules de cellules de convertisseur.

13. Convertisseur modulaire multiniveau selon l'une quelconque des revendications précédentes, dans lequel le premier collecteur comprend au moins un tronçon électriquement isolant (123, 223), un tronçon électriquement isolant étant agencé entre l'unité de conditionnement d'air et un deuxième collecteur, et/ou un tronçon électriquement isolant étant prévu entre deux deuxièmes collecteurs, un tronçon électriquement isolant étant configuré pour assurer une isolation électrique jusqu'à une différence de potentiel de tension entre l'unité de conditionnement d'air et un deuxième collecteur, ou entre deux deuxièmes collecteurs.

14. Convertisseur modulaire multiniveau selon l'une quelconque des revendications précédentes, dans lequel un connecteur de gaine d'un module de cellules de convertisseur comprend un isolateur électrique (143, 243, 443) pour assurer une isolation électrique jusqu'à une différence de potentiel de tension entre le module de cellules de convertisseur et le deuxième collecteur connecté au module de cellules de convertisseur.

15. Convertisseur modulaire multiniveau selon l'une quelconque des revendications précédentes, dans lequel la pluralité de modules de cellules de convertisseur est regroupée en une pluralité de couches, et dans lequel les modules de cellules de convertisseur d'une couche sont connectés à l'unité de conditionnement d'air par l'intermédiaire d'un deuxième collecteur dédié.

16. Convertisseur modulaire multiniveau selon l'une quelconque des revendications précédentes, le convertisseur étant un convertisseur de puissance haute tension d'un système de transmission en courant continu haute tension, HVDC, ou d'un système de transmission flexible en courant alternatif, FACTS.
